# EUROPEAN PATENT APPLICATION

(11) **EP 1 642 999 A1**
(43) Date of publication of application: **05.04.2006**
(21) Application number: 04746627.1
(22) Date of filing: 29.06.2004
(51) Int. Cl.: C23C 14/32, B23B 27/14, B23B 51/00, B23P 15/28

(54) **MULTINARY DEPOSITION FILM PRODUCTION STABILIZING DEVICE AND METHOD, AND TOOL WITH MULTINARY DEPOSITION FILM**

(30) Priority: 30.06.2003 JP 2003187564; 18.09.2003 JP 2003325405
(71) Applicant: Nachi-Fujikoshi Corp., Toyama-shi, Toyama 930-8511 (JP)
(72) Inventor: Sato, Hideki, Toyama-shi, Toyama 9300964 (JP); Sonobe, Masaru, Nakaniikawa-gun, Toyama 9300284 (JP); Kato, Norihiro, Toyama-shi, Toyama 9318328 (JP); Yasuoka, Manabu, Toyama-shi, Toyama 9398192 (JP)
(74) Representative: Henkel, Feiler & Hänzel
(86) International application number: PCT/JP2004/009158
(87) International publication number: WO 2005/001154

(57) **Abstract**

A production stabilizing device and a method produce a multicomponent film containing metal components such as TiAlN having greatly different melting points at high material use efficiency and in a good film quality by using a single crucible (3) and converged plasma (7). For this end, electric power required to evaporate material (4) is first supplied and then electric power stepwise increased from the first electric power is repeatedly supplied until a required maximum electric power is reached. Alternatively, plasma control is performed for converging the plasma (7) into an initial area required to evaporate the material and subsequently plasma control is performed for successively and stepwise moving and expanding the plasma from the initial plasma area up to a maximum plasma area to gradually melt a non-melted portion (4b) of the material. The material is a sintered compact or a green compact (4).

## Description

### TECHNICAL FIELD

The present invention relates to production stabilizing device and method which can more easily produce a nitride, a carbide, a boride, an oxide or a silicide containing two or more metal components such as TiAlN than prior art, and relates to a coated tool with a film formed by the method.

### BACKGROUND ART

A PVD (Physical Vapor Deposition) method has been known as a method of coating a product surface to give it abrasion resistance, oxidation resistance, corrosion resistance and other some functions.
An ion plating method, which is used as one of the PVD method and combines one part of a vacuum deposition method with a sputtering process, is a surface treatment method for forming a coating of a metal compound such as a metal carbide, a metal nitride and a metal oxide or a compound thereof. This method is now significant as the method of coating particularly the surface of a sliding member and a cutting tool.

Conventionally, a nitride containing two or more metal components such as a TiAlN film has been exclusively produced by an arc process or a sputtering process.
However, these methods need an expensive alloy target serving as a vaporizing material and need to prepare the target of a composition according to an objective film composition. Further, the methods hardly use the whole of a raw material, by reason of an electromagnetic field and a holding method of the target. In addition, the arc process inevitably involves deposition of unreacted metal droplets and can not form a film with satisfactory quality. The sputtering process can form an extremely flat film, but has generally a small film-forming rate.

On the contrary, a melting-evaporation type ion plating method (hereafter referred to as a melting method), has an advantage of evaporating most of a charged raw material and a high material use efficiency. This is particularly advantageous when using a metal of high material unit cost or a hardly formable metal as the raw material. However, the conventional melting method has difficulty in uniformly evaporating two or more sorts of metal materials with remarkably different melting points.

For instance, when two or more sorts of metal elements with largely different melting points such as Ti and Al are melted in the same crucible with a conventional method, Al with a low melting point precedently melts and vaporizes, and subsequently Ti does. As a result, the obtained film has a composition affected by the difference of the melting points, specifically contains a high ratio of the low-melting metal on a base metal side, and contains gradually a high ratio of the high-melting metal toward a surface layer.
Thus, the film containing two or more sorts of metal elements formed with the conventional method has a distributed composition wholly depending on their melting points, and accordingly has had difficulty in controlling the composition distribution in a film thickness direction. It was almost impossible to control the film on the base metal side so as to contain a higher ratio of the high-melting metal, and the film on the surface side so as to contain a higher ratio of the low-melting metal.

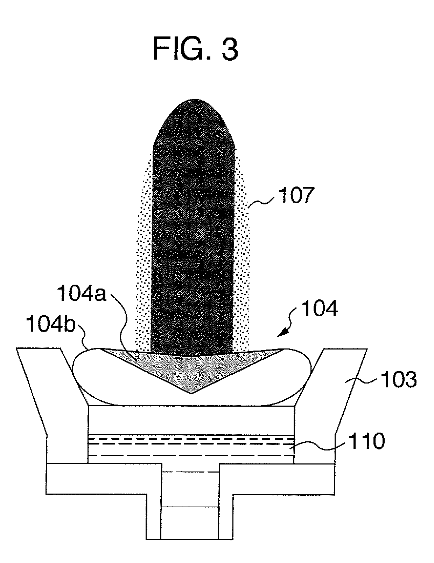

In particular, when a melting material made of an alloy is used as a starting material, a sufficient unmelted portion is required to form a thick film, the material has to have a large area. However, a melted portion overlies the unmelted portion, and a complicated control unit is required for moving the melted portion.
Such a situation is illustrated in Fig. 3. Fig. 3 shows a state that a TiAlN film is formed using a conventional melting material made of an alloy. The alloy 104 of the melting material is shaped to have a wide area and is placed in a water cooled 110 type crucible 103. Alloy vapor is ionized by converged plasma 107. The melted portion 104a of the alloy largely overlaps with the unmelted portion 104b.

In order to solve such a problem, a method of installing a plurality of evaporation sources in an ion plating apparatus has been adopted, for instance, as seen in JP-U-06-33956 (Fig. 1).
However, in order to provide the plurality of evaporation sources, the ion plating apparatus needs an additional power supply. Further, In addition, a film-forming rate by the melting method depends on a distance or positional relation of the evaporation source from or with an article to be vapor-deposited, but it is difficult for the apparatus having the plurality of evaporation sources to uniformize the positional relationship between the plurality of evaporation sources and the article to be vapor-deposited. For this reason, it is almost impossible to obtain a film having a consistent composition.

### DISCLOSURE OF THE INVENTION

### PROBLEM TO BE SOLVED BY THE INVENTION

Accordingly, it is desired to form a multicomponent film containing metal components such as TiAIN having greatly different melting points in adequate quality, for instance, in which each component of different metals is distributed at a desired rate over the whole film thickness. It is also preferable to form the film at high material use efficiency by using a raw material alloy which has metal components not required to be strictly matched with an objective film composition but almost close to the objective film composition, and of which the whole part can be effectively used.
The invention has an object of providing production stabilizing device and method for forming such a multicomponent film and a tool coated with the film formed by using the method.

### MEANS FOR SOLVING THE PROBLEM

Multicomponent film production stabilizing device and method according to the invention melt and evaporate a vaporizing material containing at least two sorts of metals, alloys or intermetallics compound in a single crucible or hearth and form a multicomponent film with use of plasma converged by an electric field or a magnetic field. At this time, a part of the material is first melted and evaporated, and then an unmelted portion of the material is sequentially melted and evaporated.

It is preferable to conduct the sequential meting and evaporating of the unmelted material portion by supplying first electric power necessary for evaporating and then supplying electric power stepwise increased from the first electric power at predetermined intervals repeatedly up the supply of necessary maximum electric power or by converging the plasma into a first plasma region necessary for evaporating the material and then sequentially moving and expanding the plasma from the first plasma region in a successive manner up to the maximum plasma region.

The above scheme allows a melted portion to be expanded during coating treatment for supplementing the metal of a low melting point.
As a result, it is possible to form a film in adequate quality, in which respective metal components with greatly different melting points of a metal such as TiAlN form a desired composition distribution over the whole film thickness by controlling the composition of a starting raw material and the melting rate of an unmelted portion. The vaporizing raw material does not need to be strictly matched with an objective film composition and may be an alloy having a metal composition approximately close to the objective film composition.

The raw material is preferably a sintered compact or a green compact.
With the use of the sintered compact or the green compact, a melted portion can be separated from an unmelted portion. The raw material can be therefore effectively used almost in entirety with the unmelted portion sequentially melted and evaporated, and the material use efficiency is high.

A coated tool according to the invention has a cutting tool base material such as a high-speed tool steel, a die steel, a cemented carbide or a cermet, and the film of a nitride, a carbide, a boride, an oxide or a silicide containing a plurality of metal elements is formed on the base material by the above method according to the invention.
Thus, the coated tool with the superior film having desired composition distribution can be obtained.

### MODE FOR CARRYING OUT THE INVENTION

The invention will be now described in detail with reference to an embodiment. At the outset, the development to the invention will be described.
The present inventors attempted to form a TiAIN film under a condition of obtaining a general TINT coating with the use of 50 g of a TiAl alloy as a melting raw material. In this attempt, the TiAl alloy was totally melted in a few minutes after having started melting. The film thus obtained had a composition in which Al was abundant on a base material side and Ti was gradually abundant toward a surface side. This is because Al has a lower melting point than Ti and precedently vaporizes from the melted material. The coating film thus obtained had a low hardness and poorer adhesiveness as compared with a TiN film.

Even when the TiAl alloy was increased in weight to make a part of the material melt, Al with a low melting point precedently vaporized and this gave the similar result.
Then, the inventors considered supplying A1 which was exhausted by evaporation, and conducted experiments of additionally charging A1 into a melted material. However, it was difficult to balance melting and evaporation with the Al supply, and a satisfactory result was not obtained.

According to the conventional technique, it is general to control electric power used for melting a raw material to approximately constant electric power determined to be optimum at first, except when starting melting.
The inventors inferred that if the electric power was increased in a stepped manner at predetermined intervals during the melting, an unmelted portion would newly start melting and supplement a low-melting metal contained in the unmelted portion to the film. They repeated many experiments and could prove correctness of the inference.

Furthermore, according to the conventional technique, also in melting an unmelted portion by controlling an electric field or a magnetic field for converging plasma, it is general to control a plasma region used for melting a raw material to an approximately constant plasma region determined to be optimum at the beginning, except when starting melting.
The inventors inferred that a similar effect would be obtained by controlling the plasma so that the plasma region was continuously moved and expanded from the first region up to the maximum plasma region by sequentially moving and expanding the plasma. They repeated many experiments and could prove correctness of the inference.

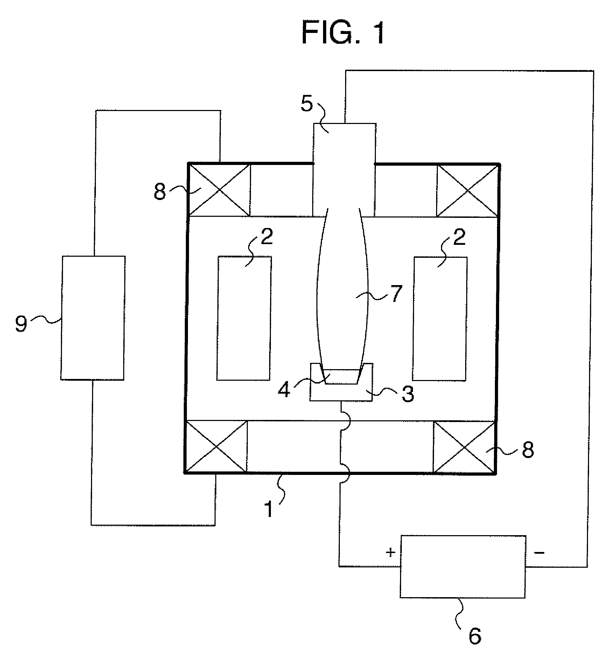

the present invention is based on such knowledge of the inventors as the above.
A production stabilizing device according to the embodiment of the invention uses a sintered compact or a green compact containing at least two sorts of metals or intermetallics compound as a vaporizing raw material, melts and evaporates the raw material to form a multicomponent film. The production stabilizing device has, as shown in Fig. 1, a vacuum chamber 1 for accommodating a member to be coated or a workpiece 2, and a single crucible or hearth 3 mounted in the chamber for receiving the green compact 4 of the raw material. The device is further equipped with a power supply unit 6 including a HCD gun (Hollow Cathode Gun) 5, which supplies an electric power to the crucible to cause arc discharge, evaporates and ionizes the raw material by the generated heat and plasma 7, and a plasma control unit 9 including an electromagnetic coil 8 for controlling a magnetic field for converging the plasma when evaporating the raw material.

The production stabilizing device of the embodiment may have the same construction as the conventional apparatus according to the melting and evaporating type ion plating method, except the power supply unit 6 and the plasma control unit 9, and further description on the same components will be omitted.
The electric power supply unit 6 has a construction for sequentially-increased electric power supply which gradually increases electric power to be supplied and sequentially melts the unmelted portion of the raw material.
The electric power supply unit 6 of the embodiment, when carrying out the sequentially-increased electric power supply, first supplies electric power of 3,000 W necessary for evaporating the raw material. The unit then supplies electric power increased by 500 W from the electric power supplied immediately before at an predetermined interval of one minute. The electric power increased by 500 W is thus repeatedly supplied up to the necessary maximum electric power of 8,000 W, and sequentially melts the unmelted portion.

The plasma control unit 9 similarly has a construction of changing the magnetic field control for converging the plasma when evaporating the raw material.
In the embodiment, when conducting the variable plasma control, the plasma control unit 9 first converges the plasma in a first plasma region necessary for evaporating the raw material, for instance a region with a diameter of 10 mm about an approximate center of the green compact 4. After that, the unit controls the plasma so as to sequentially move and expand it from the immediately preceding plasma region. The plasma is thus continuously and sequentially moved and expanded up to the maximum plasma region with a diameter of 40 mm almost covering the whole green compact, and sequentially melts the unmelted portion.

Examples of tools with films formed by the method according to the invention will be described below.

### [Example 1]

A vaporizing raw material was prepared by die-molding 30 g of a mixed powder of Ti and Al having metal components approximately close to an objective film composition into a tubular shape having a diameter of 40 mm, with the force of 2 GPa. The green compact was charged into the crucible (or hearth), the workpiece was heated and cleaned, and then, the green compact was melted and evaporated in a mixture atmosphere of argon and nitrogen gases at a pressure of about 1 Pa. At this time, a HCD gun was used, which was set to converge the diameter of a plasma beam into about 10 mm on the top face of the green compact, and a plasma output was increased by 500W per minute up to 8,000W.

At the same time, the plasma control was performed so as to continuously and sequentially move and expand the diameter of the plasma beam from the region of the 10mm diameter about the approximate center of the green compact so as to finally cover almost the entire green compact of the 40 mm diameter to sequentially melt the unmelted portion.
A TiAlN film was formed from thus obtained vapor of the raw material on a high speed steel drill and a cemented carbide end mill which had a TiCN coating coated beforehand as an undercoat.

The result of a cutting test with the obtained high speed steel drill is shown in Table 1 (item name: drill life). The test was conducted to use the high speed steel drill in cutting up to the breakage life.

### (Cutting condition of the high speed steel drill)

tool: high speed steel drill of φ6
cutting method: drilling, using 5 pieces of each example
work material: S50C (hardness 210 HB)
cutting speed: 40 m/min, feed: 0.1 mm/rev
cutting length: 20 m (through hole), lubricant: dry type (none)

**[Table 1]**

| | Film thickness * µm | Film hardness HV0.05 | Drill life (hole) | End mill flank wear V_{B}(mm) | Qxidizstion thickness µm | |
|---|---|---|---|---|---|---|
| TiCN+TiAlN (green compact melting method) | Surface layer 1.3 Undercoat 1. 6 | 3400 | 987 | 0.04 | 0.4 | Invention |
| TiCN (melting method) | 2.1 | 2800 | 416 | 17m stopped | All oxidized | Comparative example |
| TiCN+TiAlN (arc prosess) | Surface layer 2.5 Undercoat 0.2 | 3800 | 489 | 0.06 | 0.6 | Comparative example |
| TiCN+TiAlN (alloy melting method) | Surface layer 0.9 Undercoat 1.7 | 3300 | 852 | 0.05 | 0.4 | Comparative example |

| | | | | | | |
|---|---|---|---|---|---|---|
| Film thicknesses are values measured on simultaneously installed test pieces of high speed steel (SKH51, Ra≤0.2µm) with a carotest method (fretting mark method). | | | | | | |

As is apparent from Table 1, the high speed steel drill with the hard film according to the invention shows the very long life almost twice as compared with the conventional examples. This is because the melting method forms almost no droplet and imparts small surface roughness.
According to the invention, the multicomponent film containing metal components with greatly different melting points such as TiAlN had such adequate film quality as to show the desired distribution of the respective, different metal components over the whole film thickness. Further, as for the vaporizing raw material, since it does not need to strictly match with the objective film composition, a raw alloy material having metal compounds approximately close to the objective film composition may be used and almost the whole parts of the material can be effectively used so that the material use efficiency is high.

The green compact 4 has the cylindrical shape and is placed in the water cooled 10 type crucible 3. The atmosphere above the crucible 3 in the vacuum chamber is made in a plasma state, and the plasma 7 is controlled to converge on the raw material. A central part of the green compact 4 is melted and evaporated by heat generated when forming the plasma, and the vapor is ionized.
When the sintered compact or the green compact is used as the starting raw material, the raw material is increased in apparent volume by heat and forms vacant gaps inside the sintered compact or green compact. The sintered compact or the green compact having the vacant gaps has a higher heat-insulating effect as compared with an alloy material and decreases the volume after having been melted. This allows the melted portion and the unmelted portion to be easily separated.

### [Example 2]

Cemented carbide inserts (A30) were coated under the condition of Example 1 and were heated to and held at 900°C for one hour in atmospheric air. The result of measuring the thicknesses of surface oxide layers of the inserts is jointly written in Table 1 (item name: oxidization thickness). It is understood that since the film has less film defects such as droplets as compared with that according to the arc process (the conventional example), progression of oxidation is slow and the thickness of an oxidized layer is small (improves oxidation resistance).

### [Example 3]

A cemented carbide end mill previously coated with a TiCN film in the condition of Example 1 was coated with a TiAlN film. A wear width in the flank of the cemented carbide end mill was measured after it had cut the length of 60 m, and the result is written together in Table 1 (item name: end mill flank wear). Cutting conditions are shown below.

### (Cutting condition of cemented carbide end mill)

tool: φ10 cemented carbide square end mill with two cutting edges
cutting method: downward side cutting
work material: SKD61 (hardness 53 HRC)
depth of cut: 10 mm in axial direction and 0.2 mm in diametrical direction
cutting speed: 314 m/min, feed: 0.07 mm/edge
cut length: 60 m, lubricant: none (air blow)
The cemented carbide end mill showed abrasion resistance equal to or slightly better than the TiAIN film formed by the arc process. Because the films have the same content, it is considered that the improvement of the oxidation resistance by reduction of droplets contributes to this result.

In the above, the invention has been described with reference to the embodiment, but the invention is not limited solely to this specific form, and the described form can be variously changed or the invention may take other forms within the scope of attached claims.
For instance, although the embodiment melts, evaporates and ionizes the raw material together by forming the plasma, melting and evaporation of the raw material and ionization thereof may be separately carried out by using a heating device capable of changing a heating region. Further, although a magnetic field is used for convergence control of the plasma in the embodiment, it is needless to say that an electric field may be used.
Furthermore, in Example 1, the power supply control and the plasma control are both used in forming the coating film, but only one control of them may be used.

### BRIEF DESCRIPTION OF THE DRAWING

[Fig. 1] A schematic view showing the whole configuration of a multicomponent film production stabilizing device according to an embodiment of the invention

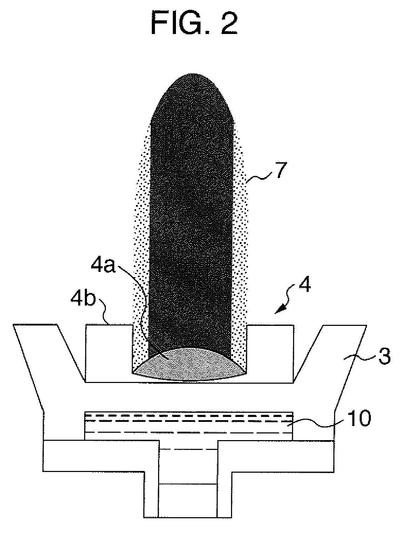

[Fig. 2] A schematic sectional view for explaining the molten state of raw material of a green compact in the device of Fig. 1
[Fig. 3] A schematic sectional view of a crucible for explaining the molten state in the case of using a raw alloy material of a large area

## Claims

1. A production stabilizing device for forming a multicomponent film by melting and evaporating a vaporizing raw material (4) containing at least two sorts of metals, alloys or intermetallics compound in a single crucible or hearth (3) with use of plasma (7) converged by an electric field or a magnetic field, the device having an electric power supply unit (6) for melting and evaporating the raw material and a plasma control unit (9) for controlling the electric field or the magnetic field, **characterized by**
a means for melting and evaporating a part of the raw material (4) and then sequentially melting and evaporating an unmelted portion (4b) of the raw material.

2. The production stabilizing device according to claim 1, wherein said means comprises a sequentially increased electric power supply unit (6) which supplies first electric power necessary to evaporate the raw material (3) and then supplies electric power gradually increased from the first electric power at predetermined intervals repeatedly up to necessary maximum electric power to sequentially melt the unmelted portion (4b).

3. The production stabilizing device according to claim 1, wherein said means comprises a plasma control unit (9) which performs plasma control of converging the plasma (7) in a first plasma region necessary to evaporate the raw material (4) and plasma control of continuously and sequentially moving and expanding the plasma from the first plasma region up to maximum plasma region to sequentially melt the unmelted portion (4b).

4. A production stabilizing method for forming a multicomponent film by melting and evaporating a vaporizing raw material (4) containing at least two sorts of metals or intermetallics compound in a single crucible or hearth (3) with use of plasma (7) converged by an electric field or a magnetic field, **characterized by**
melting and evaporating a part of the raw material (4) and then sequentially melting and evaporating an unmelted portion (4b) of the raw material.

5. The production stabilizing method according to claim 4, wherein the sequentially melting and evaporating the unmelted portion of the raw material (4) comprises supplying first electric power necessary to evaporate the raw material and then supplying electric power gradually increased from the first electric power at predetermined intervals repeatedly up to necessary maximum electric power to sequentially melt the unmelted portion (4b).

6. The production stabilizing method according to claim 4, wherein the sequentially melting and evaporating the unmelted portion of the raw material (4) comprises converging the plasma (7) in a first plasma region necessary to evaporate the raw material and then continuously and sequentially moving and expanding the plasma from the first plasma region up to a maximum plasma region to sequentially melt the unmelted portion (4b).

7. The production stabilizing method according to any one of claims 4 to 6 further comprising using a sintered compact or a green compact (4) for the raw material.

8. A coated tool comprising a cutting tool base material of a high-speed tool steel, a die steel, a cemented carbide, a cermet or the like and a coating film of a nitride, a carbide, a boride, an oxide or a silicide containing a plurality of metallic elements and formed on the base material by the method of claim 4.
